# EUROPEAN PATENT APPLICATION

(11) **EP 2 584 610 A2**
(43) Date of publication of application: **24.04.2013**
(21) Application number: 12162304.5
(22) Date of filing: 29.03.2012
(51) Int. Cl.: H01L 31/0352, H01L 31/075, H01L 31/0224

(54) **Photoelectric device**

(30) Priority: 18.10.2011 US 201161548401 P; 20.03.2012 US 201213424450
(71) Applicant: Samsung SDI Co., Ltd., Yongin-si, Gyeonggi-do (KR)
(72) Inventor: Lee, Doo-Youl, Gyeonggi-do (KR); Kim, Young-Jin, Gyeonggi-do (KR); Kim, Dong-Seop, Gyeonggi-do (KR); Mo, Chan-Bin, Gyeonggi-do (KR); Kim, Young-Su, Gyeonggi-do (KR); Park, Young-Sang, Gyeonggi-do (KR)
(74) Representative: Mounteney, Simon James

(57) **Abstract**

A photoelectric device comprising: a substrate; a first conductive semiconductor layer situated over a first surface of the substrate; a second conductive semiconductor layer situated over the said first surface of the substrate; a first electrode situated over the first conductive semiconductor layer; and a second electrode situated over the second conductive semiconductor layer; wherein one of the first and second conductive semiconductor layers is an emitter layer and the other of the first and second conductive semiconductor layers is a base layer; characterised in that the first conductive semiconductor layer covers a greater proportion of the said first surface of the substrate than the second conductive semiconductor layer covers.

## Description

The present invention relates to a photoelectric device.

Due to problems such as the exhaustion of energy resources and environmental pollution of the earth, the development of clean energy sources has recently accelerated. Photovoltaic energy is considered to be such a clean energy source as it is generated from sunlight using solar cells.

However, the costs of generating photovoltaic energy by using solar cells are high in comparison to the generation of thermal energy, and the power generation efficiency of the solar cells has to be increased to allow broad application of solar cells. In order to increase power generation efficiency, a light loss and a surface recombination loss may be reduced and a serial resistance of photocurrents generated by solar cells may also be reduced.

The present invention sets out to provide a photoelectric device that is capable of increasing the collection efficiency of a carrier generated by light, and reducing the serial resistance of photocurrent paths.

According to one or more embodiments of the present invention a photoelectric device includes the features of Claim 1. Preferred features of the invention are set out in Claims 2 to 17.

### Brief Description of the Drawings

Embodiments of the invention will be described by way of example, with reference to the accompanying drawings, in which:-
FIG. 1 is a schematic perspective view of a photoelectric device according to an embodiment of the present invention;
FIG. 2 is a cross-sectional view of the photoelectric device taken from a line II-II of FIG. 1;
FIG. 3A is a schematic plan view of an arrangement relationship between first and second semiconductor structures;
FIG. 3B is a schematic plan view of an arrangement relationship between first and second semiconductor structures and first and second electrodes;
FIG. 3C is a schematic plan view of an arrangement of an interlayer insulating layer;
FIG. 4 is a schematic perspective view of a photoelectric device according to another embodiment of the present invention;
FIG. 5 is a cross-sectional view of the photoelectric device taken from a line V-V of FIG. 4; and
FIGS. 6A through 6V are sequential cross-sectional views for describing a method of manufacturing a photoelectric device, according to an embodiment of the present invention.

### Detailed Description

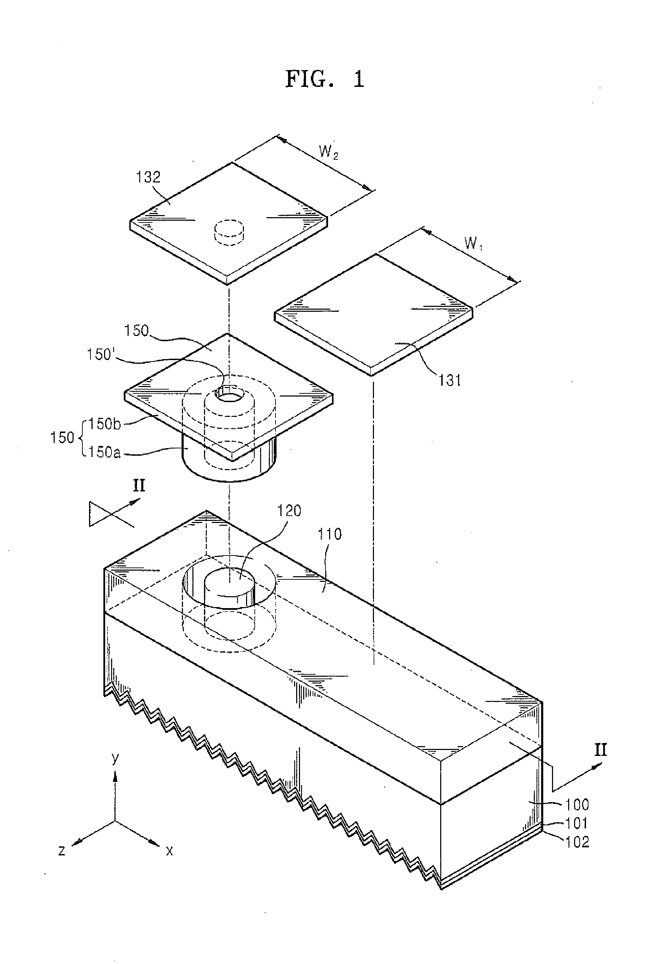

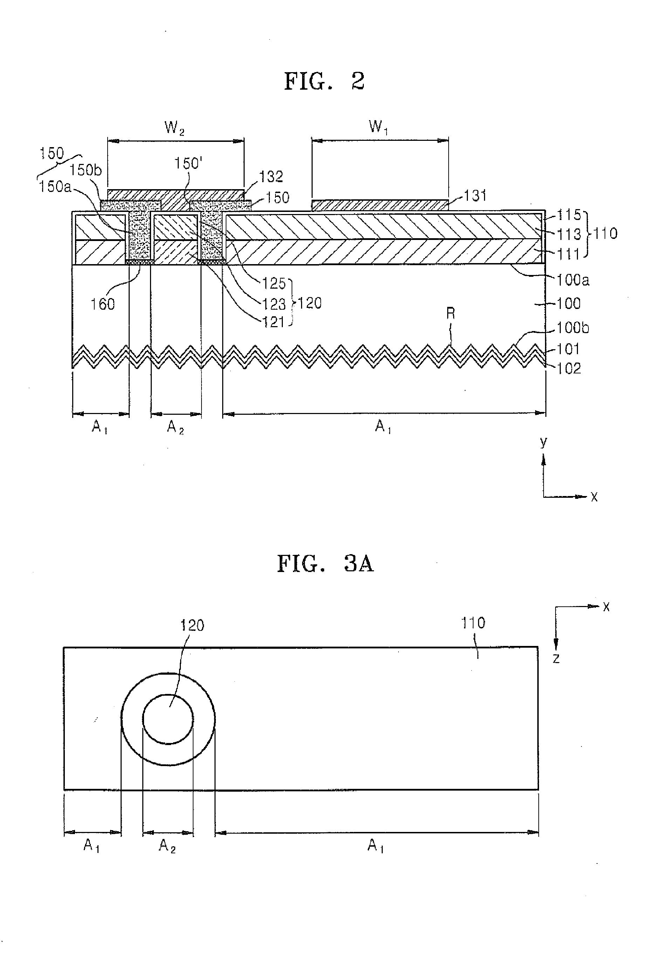

FIG. 1 is a schematic perspective view of a photoelectric device according to an embodiment of the present invention. FIG. 2 is a cross-sectional view of the photoelectric device taken from a line II-II of FIG. 1.

Referring to FIGS. 1 and 2, the photoelectric device includes a semiconductor substrate 100, a first semiconductor structure 110 having a first conductive type and a second semiconductor structure 120 having a second conductive type formed on the semiconductor substrate 100, first and second electrodes 131 and 132 electrically connected to the first semiconductor structure 110 and the second semiconductor structure 120, and a second interlayer insulating layer 150b disposed between the second electrode 132 and the first semiconductor structure 110.

In the present embodiment, the first semiconductor structure 110 is formed in a relatively wide region, so as to surround the second semiconductor structure 120, which has a dot or island configuration. The first and second semiconductor structures 110 and 120 having opposite conductive types are spatially spaced apart from each other and electrically insulated from each other by a first interlayer insulating layer 150a that extends between the first and second semiconductor structures 110 and 120 in y- direction.

The second interlayer insulating layer 150b functions to prevent an electrical short circuit between the first semiconductor structure 110 and the second electrode 132 connected to the second semiconductor structure 120 having a conductive type opposite to that of the first semiconductor structure 110.

Referring to FIG. 2, the semiconductor substrate 100 has a first surface 100a and a second surface 100b opposite to the first surface 100a. A back-contact, in which the first and second electrodes 131 and 132 of an emitter and a base are formed is formed on the first surface 100a. The second surface 100b, in the absence of an electrode structure, functions as a light receiving surface, thereby increasing effective incident light and reducing light loss. This structure reduces light loss, and results in a high output compared to a conventional solar cell, in which an electrode is also formed on the surface that functions as the light receiving surface.

The semiconductor substrate 100 may generate carriers as a consequence of receiving light through the second surface 100b. The carriers generated by light (hereinafter referred to as "carriers") are holes and electrons generated when light is absorbed into the semiconductor substrate 100. The semiconductor substrate 100 may be formed as, e.g., a single crystal or poly crystal silicon substrate having an n or p conductivity type. For example, according to one embodiment of the present invention, the semiconductor substrate 100 may be formed as a p-type single crystal silicon substrate. A texture structure R including a roughness pattern is formed on the second surface 100b of the semiconductor substrate 100. The texture structure R serves to reduce reflectance of incident light, and form a roughness surface including a plurality of minute protrusions.

A passivation layer 101 is formed on the second surface 100b of the semiconductor substrate 100. The passivation layer 101 may suppress surface recombination of carriers generated by the semiconductor substrate 100 and thus improve carrier collection efficiency. For example, the passivation layer 101 may improve carrier collection efficiency by reducing surface recombination of carriers due to a defective of the surface of the semiconductor substrate 100. For example, the passivation layer 101 may include an intrinsic semiconductor layer, a doped semiconductor layer, a silicon oxide layer (SiOx), or a silicon nitride layer (SiNx). The intrinsic semiconductor layer and the doped semiconductor layer may be formed of amorphous silicon deposited on the semiconductor substrate 100.

The passivation layer 101 may be formed of amorphous silicon (a-Si) doped in the same conductive type as that of the semiconductor substrate 100, and may be doped at a higher density than the semiconductor substrate 100 and thus form a surface field suppressing surface recombination of carriers.

An antireflective layer 102 is formed on the passivation layer 101. The antireflective layer 102 may include silicon oxide (SiOx) or silicon nitride (SiNx). For example, the antireflective layer 102 may be formed as a single layer of silicon oxide (SiOx) or a combination of a silicon oxide layer (SiOx) and a silicon nitride layer (SiNx) having different refractive indexes.

Although the passiviation layer 101 and the antireflective layer 102 have separate layer structures according to this embodiment of the present invention, the passiviation layer 101 and the antireflective layer 102 may be formed as a single layer in another embodiment of the present invention. For example, a hydrogenated silicon nitride (SiN:H) layer may be formed to obtain passivation and antireflection effects.

First and second semiconductor structures 110 and 120 having inverse conductivity types are formed on the first surface 100a of the semiconductor substrate 100. The first and second semiconductor structures 110 and 120 include the emitter and the base that separate and collect the carriers generated by the semiconductor substrate 100.

The first semiconductor structure 110 includes a first intrinsic semiconductor layer 111 and a first conductive semiconductor layer 113 sequentially stacked on the semiconductor substrate 100. The first intrinsic semiconductor layer 111 and the first conductive semiconductor layer 113 may be formed of amorphous silicon (a-Si) or micro crystalline silicon (µc-Si).

The first intrinsic semiconductor layer 111 may be formed by not adding a dopant or by adding a small amount of dopants. The first intrinsic semiconductor layer 111 may passivate the surface of the semiconductor substrate 100 to suppress recombination of the carriers generated by the semiconductor substrate 100, and enhance the interface characteristics between the semiconductor substrate 100 formed of crystalline silicon and the first conductive semiconductor layer 113 formed of amorphous silicon.

The first conductive semiconductor layer 113 may be formed by adding a p or n type dopant. For example, the first conductive semiconductor layer 113 may be doped in a p conductivity type inverse to that of the semiconductor substrate 100 having the n conductivity type, and may form the emitter of collecting minority carriers (e.g. holes) from the semiconductor substrate 100 having the n conductivity type.

The first semiconductor structure 110 includes a first transparent conductive layer 115 formed on the first conductive semiconductor layer 113. The first transparent conductive layer 115 may be formed of an electrically conductive and optically transparent material. For example, the first transparent conductive layer 115 may be formed of transparent conducting oxide (TCO) such as indium tin oxide (ITO), zinc oxide (ZnO), etc.

The first transparent conductive layer 115 is formed along external surfaces of the first conductive semiconductor layer 113 and the first intrinsic semiconductor layer 111 and forms an electrical contact in a wide region, thereby reducing a contact resistance and mediating a connection between the first semiconductor structure 110 and the first electrode 131.

The second semiconductor structure 120 includes a second intrinsic semiconductor layer 121 and a second conductive semiconductor layer 123 sequentially stacked on the semiconductor substrate 100. The second intrinsic semiconductor layer 121 and the second conductive semiconductor layer 123 may be formed of amorphous silicon (a-Si) or micro crystalline silicon (µc-Si).

The second intrinsic semiconductor layer 121 may be formed by not adding a dopant or by adding a small amount of dopants. For example, the second intrinsic semiconductor layer 121 may passivate the surface of the semiconductor substrate 100 to suppress recombination of the carriers generated by the semiconductor substrate 100, and enhance the interface characteristics between the semiconductor substrate 100 formed of crystalline silicon and the second conductive semiconductor layer 123 formed of amorphous silicon.

The second conductive semiconductor layer 123 may be formed by adding a p or n type dopant. For example, the second conductive semiconductor layer 123 may be doped in an n conductivity type that is the same as that of the semiconductor substrate 100, and may form the base of collecting a plurality of carriers (e.g. electrons) from the semiconductor substrate 100 in the n conductivity type.

The second semiconductor structure 120 may include a second transparent conductive layer 125 formed on the second conductive semiconductor layer 123. The second transparent conductive layer 125 may be formed of an electrically conductive and optically transparent material. For example, the second transparent conductive layer 125 may be formed of transparent conducting oxide (TCO) such as indium tin oxide (ITO), zinc oxide (ZnO), etc.

The second transparent conductive layer 125 is formed along external surfaces of the second conductive semiconductor layer 123 and the second intrinsic semiconductor layer 121 and forms an electrical contact in a wide region, thereby reducing a contact resistance, and mediating a connection between the second semiconductor structure 120 and the second electrode 132.

Although the first and second semiconductor structures 110 and 120 are singular in FIG. 1, the first and second semiconductor structures 110 and 120 may be plural according to the first surface 100a of the semiconductor substrate 100.

Although the first and second semiconductor structures 110 and 120 that form the emitter and the base include the first and second intrinsic semiconductor layers 111 and 121 and the first and second conductive semiconductor layers 113 and 123 in FIG. 2, the first and second semiconductor structures 110 and 120 need not include the first and second intrinsic semiconductor layers 111 and 121 and may include the first and second conductive semiconductor layers 113 and 123 according to another embodiment of the present invention.

Although the first and second semiconductor structures 110 and 120 include the first and second transparent conductive layers 115 and 125 that mediate an electrical connection between the first and second electrodes 131 and 132 in FIG. 2, the first and second semiconductor structures 110 and 120 need not include the first and second transparent conductive layers 115 and 125, and, for example, may include the first and second electrodes 131 and 132 on the first and second semiconductor structures 110 and 120 excluding the first and second transparent conductive layers 115 and 125 according to another embodiment of the present invention.

First and second semiconductor regions A1 and A2 in which the first and second semiconductor structures 110 and 120 are projected on the semiconductor substrate 100 have different areas. As will be described later, the first semiconductor region A1 on the emitter of collecting minority carriers has a relatively increased structure in order to increase collection efficiency of minority carriers.

FIG. 3A is a schematic plan view of an arrangement relationship between first and second semiconductor structures 110 and 120. Referring to FIG. 3A, the first and second semiconductor structures 110 and 120 cover respectively different proportions of the semiconductor substrate 100. For example, the first semiconductor structure 110 that collects minority carriers of the semiconductor substrate 100 has a relatively wide area and covers a relatively large proportion of the semiconductor substrate 100, thereby enhancing collection efficiency of carriers. Meanwhile, although the second semiconductor structure 120 that collects majority carriers of the semiconductor substrate 100 has a relatively narrow area, collection efficiency of carriers does not deteriorate. That is, the area of the first semiconductor structure 110 is relatively large, thereby enhancing collection efficiency of carriers.

When comparing the areas of the first and second semiconductor regions A1 and A2 in which the first and second semiconductor structures 110 and 120 are projected on the semiconductor substrate 100, the area of the first semiconductor region A1 is relatively wider than the area of the second semiconductor region A2. More specifically, the second semiconductor structure 120 is formed having a dot or island configuration, and the first semiconductor structure 110 surrounds the second semiconductor structure 120.

The second semiconductor structure 120 is formed having an isolation configuration, and the first semiconductor structure 110 is formed in a large area surrounding the second semiconductor structure 120, thereby relatively increasing the area of the first semiconductor structure 110 and enhancing collection efficiency of carriers generated by light. That is, the second semiconductor structure 120 has isolation structure in order to increase the area of the first semiconductor structure 110 on the semiconductor substrate 100, so that a first semiconductor structure 110 having a relatively large area surrounding the second semiconductor structure 120 may be formed.

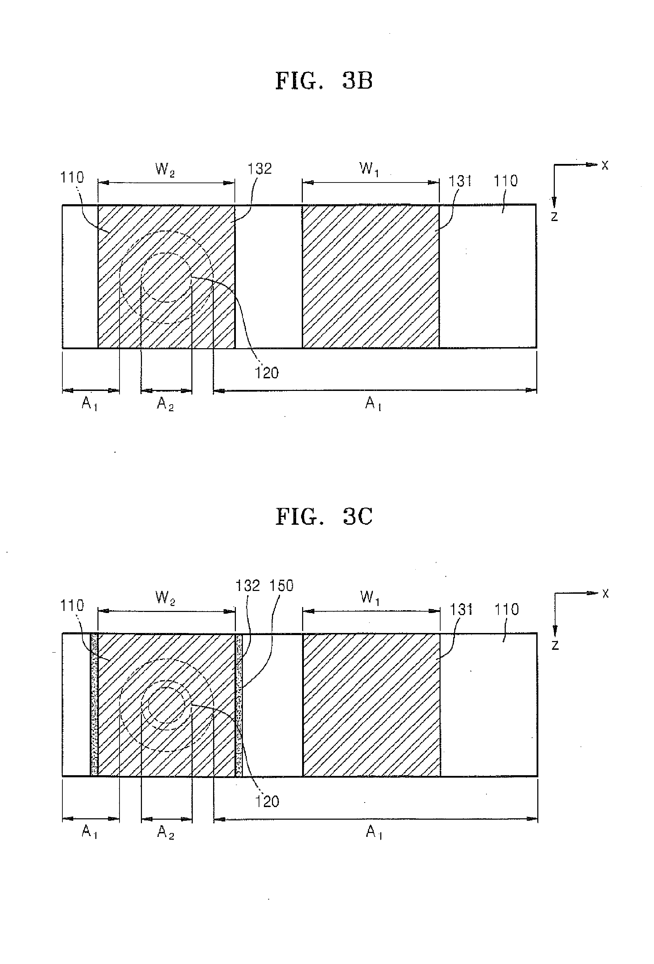

FIG. 3B is a schematic plan view of an arrangement relationship between the first and second semiconductor structures 110 and 120 and the first and second electrodes 131 and 132. Referring to FIG. 3B, the first and second electrodes 131 and 132 are formed on the first and second semiconductor structures 110 and 120. The first and second electrodes 131 and 132 are connected to the first and second semiconductor structures 110 and 120 and thus carriers generated by light may be withdrawn to the outside.

The first and second electrodes 131 and 132 may be formed of a metallic material such as silver (Ag), aluminum (Al), copper (Cu), nickel (Ni), etc. Although the first second electrodes 131 and 132 have wide shapes in a width direction (x direction) in FIG. 1 for understanding convenience, the first and second electrodes 131 and 132 may be formed in a stripe pattern in a current withdrawal direction (z direction).

The first and second electrodes 131 and 132 serve to provide photocurrent paths, and have the same or similar electrode area in order to reduce a serial resistance of the photocurrent paths. For example, if one of the first and second electrodes 131 and 132 has a relatively narrow area, the first and second electrodes 131 and 132 having narrow areas may function as limiting conductivity of photocurrent paths. Therefore, the first and second electrodes 131 and 132 are uniformly designed to have equal areas, thereby reducing the serial resistance of photocurrent paths.

Referring to FIG. 3B, widths W1 and W2 of the first and second electrodes 131 and 132 are uniform, and substantially the same as each other. In this regard, the second electrode 132 is wider than the second semiconductor structure 120 that is electrically connected to the second electrode 132 and thus the first electrode 131 and the second electrode 132 may be uniform. The second electrode 132 extends to the first semiconductor region A1 having a conductive type opposite to that of the second electrode 132 beyond the second semiconductor region A2 having the same conductive type as that of the second electrode 132, and is therefore formed over the first and second semiconductor regions A1 and A2. Therefore, as shown in FIG. 3C, the interlayer insulating layer 150 disposed between the second electrode 132 and the first semiconductor structure 110 may prevent an electrical circuit short therebetween.

According to an embodiment of the present invention, the first and second semiconductor structures 110 and 120 are designed to have different areas to increase collection efficiency of carriers while the first and second semiconductor structures 110 and 120 are uniformly designed to have equal areas to reduce a serial resistance. Accordingly, the second electrode 132 is not limited to the second semiconductor region A2 of the relatively narrow area and may extend to the first semiconductor region A1 having a conductive type opposite to that of the second semiconductor region A2 and thus the area of the second electrode 132 and the area of the first electrode 131 may be uniform.

The second interlayer insulating layer 150b is formed between the second electrode 132 and the first semiconductor structure 110. The second interlayer insulating layer 150b is formed in a region where the second electrode 132 and the first semiconductor structure 110 overlap since the second electrode 132 extends to the first semiconductor region A1 having a conductive type opposite to that of the second electrode 132, thereby preventing an electrical circuit short between the second electrode 132 and the first semiconductor structure 110.

Referring to FIG. 2, the second interlayer insulating layer 150b is formed on a part of the first semiconductor structure 110, more specifically, on the first semiconductor structure 110 that overlaps the second electrode 132. As shown, the first interlayer insulating layer 150a is formed on the second semiconductor structure 120 as well as the first semiconductor structure 110, and has a sufficient thickness that the first and second semiconductor structures 110 and 120 are planarized by burying between the first and second semiconductor structures 110 and 120. The second electrode 132 is formed on the planar surface of the second interlayer insulating layer 150b. The second interlayer insulating layer 150b stably contacts the second electrode 132 and the second semiconductor structure 120 through the via hole 150'.

Meanwhile, reference numeral 160 of FIG. 2 denotes a gap insulating layer. The gap insulating layer 160 serves to cover between the first semiconductor region A1 and the second semiconductor region A2, passivate the surface of the semiconductor substrate 100 exposed between the first and second semiconductor regions A1 and A2, and is formed to insulate the first and second semiconductor regions A1 and A2 from each other.

The gap insulating layer 160 may include an oxide layer (SiOx) or a nitride layer (SiNx). When including the nitride layer, the gap insulating layer 160 may have a negative fixed charge, and reduce surface recombination loss of carriers by preventing electrons from moving to the surface of the semiconductor substrate 100 in which the gap insulating layer 160 is formed.

In this embodiment, the first interlayer insulating layer 150a is a lower portion of an integral structure 150 that separates the first and second semiconductor structures 110 and 120, and the second interlayer insulating layer 150b is an upper portion that separates the second electrode 132 from the first semiconductor layer. Although these two portions 150a, 150b are integral parts of the same layer 150, in this embodiment they need not be and they could be separately formed. In some embodiments, one or the other could be omitted, as each provides an independent technical benefit, as described above.

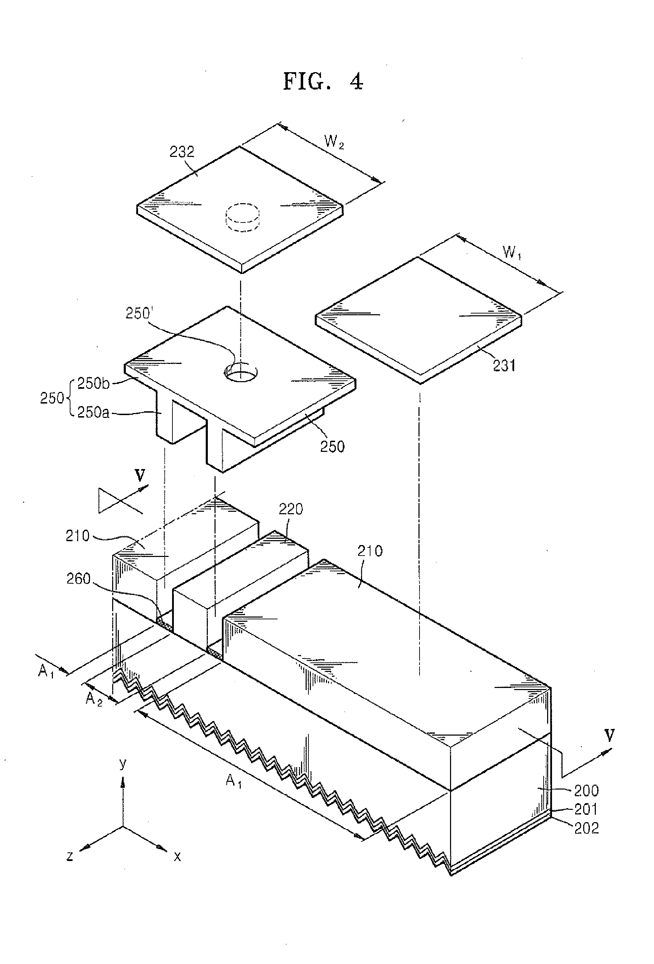

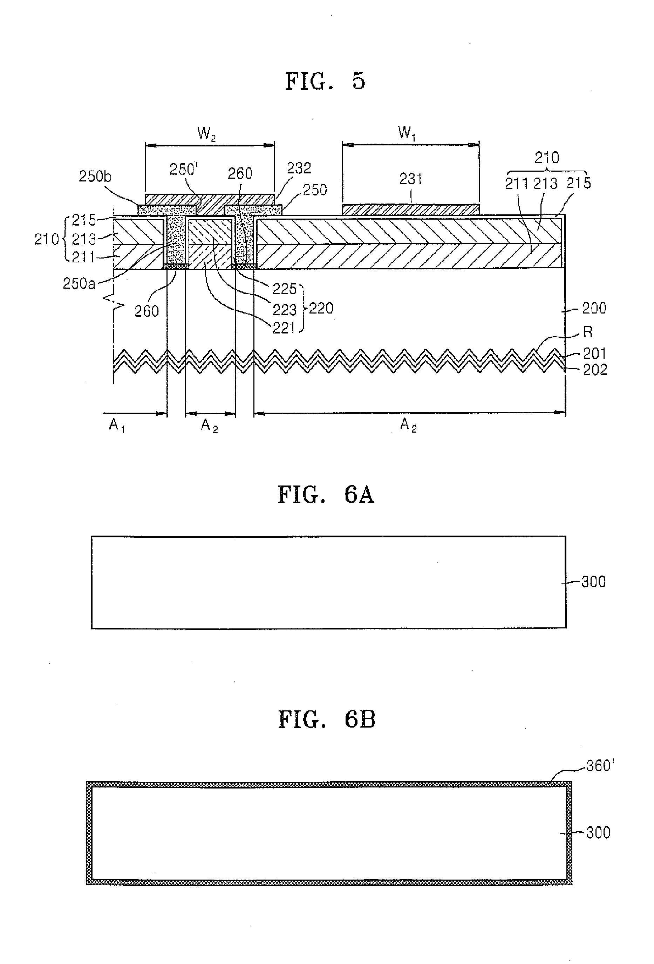

FIG. 4 is a schematic perspective view of a photoelectric device according to another embodiment of the present invention. FIG. 5 is a cross-sectional view of the photoelectric device taken from a line V-V of FIG. 4.

Referring to FIGS. 4 and 5, the photoelectric device includes a semiconductor substrate 200, a first semiconductor structure 220 having a first conductivity type, a second semiconductor structure 220 having a second conductivity type formed on the semiconductor substrate 200, first and second electrodes 231 and 232 electrically connected to the first semiconductor structure 210 and the second semiconductor structure 220, and a second interlayer insulating layer 250b disposed between the second electrode 232 and the first semiconductor structure 210.

Reference numerals A1 and A2 denote first and second semiconductor regions in which the first and second semiconductor structures 210 and 220 are projected on the semiconductor substrate 200. However, A1 and A2 may be used to indicate widths of the first and second semiconductor structures 210 and 220 below.

The first and second semiconductor structures 210 and 220 are alternatingly formed on the semiconductor substrate 200. FIGS. 4 and 5 illustrate a part of a plurality of alternately formed first and second semiconductor structures 210 and 220. In FIGS. 4 and 5, the first semiconductor structures 210 are disposed in both sides of the second semiconductor structures 220. The first semiconductor structures 210 disposed on both sides of the second semiconductor structures 220 have substantially the same structure, and are spaced apart from each other.

In the present embodiment, the first semiconductor structure 210 is formed over a relatively wide region, and extends in parallel to the second semiconductor structure 220, which has a linear shape in one direction (z direction). The first and second semiconductor structures 210 and 220 are spatially spaced and electrically insulated from each other, or insulated by the first interlayer insulating layer 250a extending between the first and second semiconductor structures 210 and 220 while extending in one direction (-y direction).

The second interlayer insulating layer 250b functions to prevent an electrical short circuit between the first semiconductor structure 210 and the second electrode 232 connected to the second semiconductor structure 220 having a conductive type opposite to that of the first semiconductor structure 210. For example, the second interlayer insulating layer 250b is formed over the first semiconductor structures 210 disposed in both sides of the second semiconductor structures 220, and may support the second electrode 232 insulated therefrom on the first semiconductor structures 210 disposed in both sides of the second semiconductor structures 220.

The first and second semiconductor structures 210 and 220 may form an emitter and a base that separate and collect carriers generated by light. The first and second semiconductor structures 210 and 220 extend in parallel to different widths A1 and A2. For example, the first semiconductor structure 210 extends in parallel to the second semiconductor structure 220 extending in one direction (z direction). The width A1 of the first semiconductor structure 210 and the width A2 of the second semiconductor structure 220 are different from each other. This is to increase collection efficiency of carriers. The first semiconductor structure 210 that collects minority carriers from the semiconductor substrate 200 has a relatively great width A1, whereas the second semiconductor structure 220 that collects majority carriers from the semiconductor substrate 200 has a relatively small width A2.

The first and second electrodes 231 and 232 are formed on the first and second semiconductor structures 210 and 220, respectively, so as to withdraw collected carriers to the outside. Although the first second electrodes 231 and 232 have wide shapes in a width direction (x direction) in FIG. 4 for understanding convenience, the first and second electrodes 231 and 232 may be formed in a stripe pattern in a current withdrawal direction (z direction). To reduce a serial resistance, the first and second electrodes 231 and 232 have equal, uniform areas and have substantially the same line widths W1 and W2.

The second electrode 232 extends to the first semiconductor region A1 having a conductive type opposite to that of the second electrode 232 beyond the second semiconductor region A2 having the same conductive type as that of the second electrode 232. For example, the second electrode 232 extends to the first semiconductor region A1 in both sides thereof. The line width W2 of the second electrode 232 is greater than the width A2 of the second semiconductor structure 220 electrically connected to the second electrode 232 and thus the line width W2 of the second electrode 232 may be uniform with the line width W1 of the first electrode 231, and a serial resistance may be reduced.

Referring to FIG. 5, the first semiconductor structure 210 includes a first intrinsic semiconductor layer 211, a first conductive semiconductor layer 213, and a first transparent conductive layer 215. However, the first intrinsic semiconductor layer 211 and the first transparent conductive layer 215 may be omitted according to a detailed structure.

The second semiconductor structure 220 includes a second intrinsic semiconductor layer 221, a second conductive semiconductor layer 223, and a second transparent conductive layer 225. However, the second intrinsic semiconductor layer 221 and the second transparent conductive layer 225 may be omitted according to a detailed structure.

The first interlayer insulating layer 250a is formed between the second electrode 232 and the first semiconductor structure 210 to insulate the second electrode 232 and the first semiconductor structure 210 from each other. The second interlayer insulating layer 250b is formed on a part of the first semiconductor structure 210, more specifically, on the first semiconductor structure 210 that overlaps the second electrode 232. The second interlayer insulating layer 250b is formed over the first semiconductor structure 210 in both sides thereof, and may be integrally formed on the second semiconductor structure 220.

The first interlayer insulating layer 250a has a sufficient thickness that the first and second semiconductor structures 210 and 220 are planarized by burying between the first and second semiconductor structures 210 and 220. The second electrode 232 may be stably formed on the planar surface of the second interlayer/insulating layer 250b. The second interlayer insulating layer 250b contacts the second electrode 232 and the second semiconductor structure 220 through a via hole 250'.

A gap insulating layer 260 is formed between the first semiconductor region A1 and the second semiconductor region A2. The gap insulating layer 260 may passivate the surface of the semiconductor substrate 200 exposed between the first and second semiconductor regions A1 and A2, and is formed to insulate the first and second semiconductor regions A1 and A2 from each other. For example, the gap insulating layer 260 may include an oxide layer (SiOx) or a nitride layer (SiNx).

Reference numerals 201 and 202 denote a passivation layer and an antireflective layer formed in a light receiving surface of the semiconductor substrate 200, respectively. The passivation layer 201 and the antireflective layer 202 are formed on a texture structure R formed in a roughness pattern.

In the embodiments of the present invention, to increase collection efficiency of carriers, the first semiconductor structure 110 is formed having a large area surrounding the second semiconductor structure 120 which has an isolation structure such as a dot or an island (FIG. 1) or may extend having a great width in parallel to the second semiconductor structure 220 having a relatively small width (FIG. 4). However, the present invention is not limited thereto. If the electrodes 131, 132, 231, and 232 of an emitter or a base extend to conductivity types opposite to those of the electrodes 131, 132, 231, and 232 beyond conductive types of the electrodes 131, 132, 231, and 232, for example, the electrodes 131, 132, 231, and 232 extend wider than the semiconductor regions A1 and A2 having the same conductive types as those of the electrodes 131, 132, 231, and 232 to reduce a serial resistance, the interlay insulating layers 150 and 250 may be disposed to prevent an electrical circuit short between the electrodes 131, 132, 231, and 232 and the semiconductor regions A1 and A2 having opposite conductive types. In this regard, the present invention may have a variety of embodiments other than those described above.

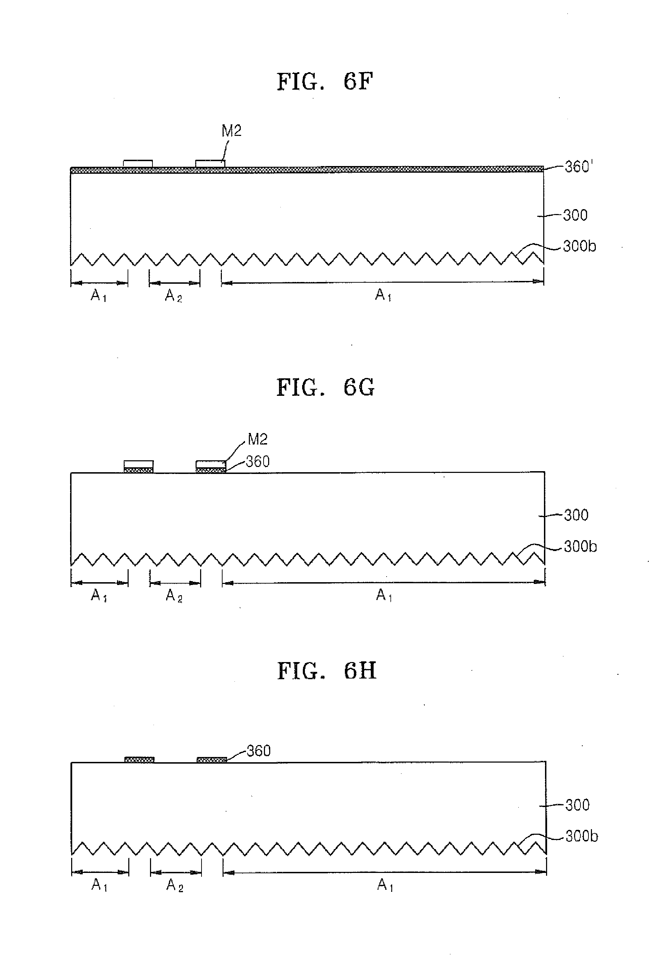

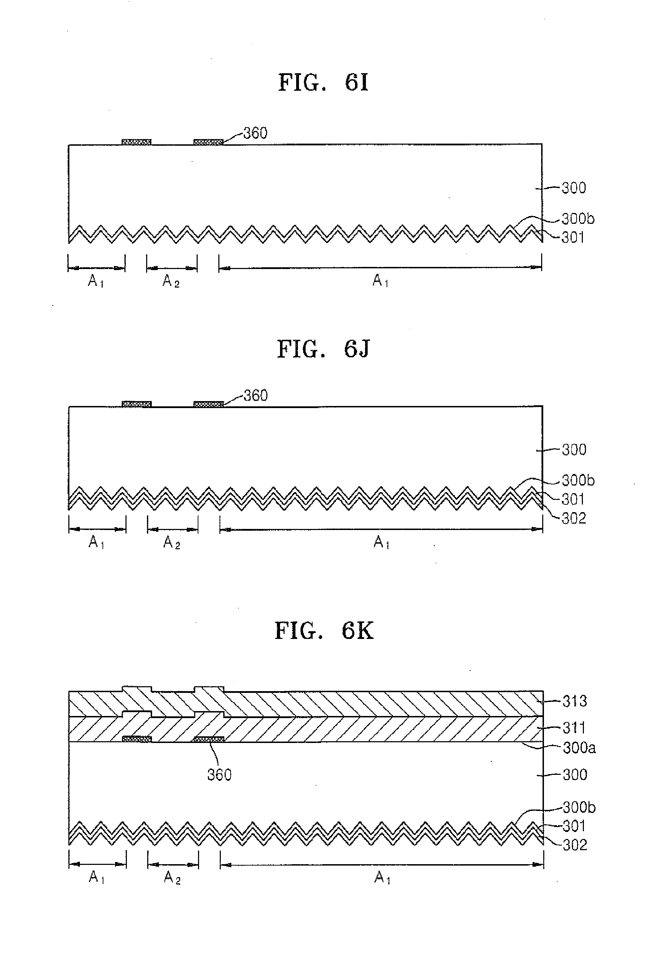

A method of manufacturing a photoelectric device according to an embodiment of the present invention will now be described with reference to FIGS. 6A through 6V.

A semiconductor substrate 300 is prepared (FIG. 6A). For example, the semiconductor substrate 300 may be formed as an n type crystalline silicon wafer. For example, a cleaning process may be performed by using an acidic or alkaline solution to remove physical or chemical impurities from a surface of the semiconductor substrate 300.

Then, an insulating layer 360' is formed on the semiconductor substrate 300 (FIG. 6B). The insulating layer 360' may function as an etching mask during a texturing process of forming a roughness pattern in the surface of the semiconductor substrate 300, and may be formed of a material that is resistant to a texturing etchant. Further, a remnant of the insulating layer 360' may cover between the first semiconductor region A1 and the second semiconductor region A2, passivate the surface of the semiconductor substrate 300 exposed between the first semiconductor region A1 and the second semiconductor region A2, and insulate the first semiconductor region A1 and the second semiconductor region A2 from each other, through patterning that will be described later.

For example, the insulating layer 360' may include an oxide layer (SiOx) or a nitride layer (SiNx), and a combination layer of the oxide layer (SiOx) and the nitride layer (SiNx). The insulating layer 360' may be formed by growing the oxide layer (SiOx) by thermal oxidation or depositing the oxide layer (SiOx) or the nitride layer (SiNx) by using a chemical vapor deposition (CVD) method.

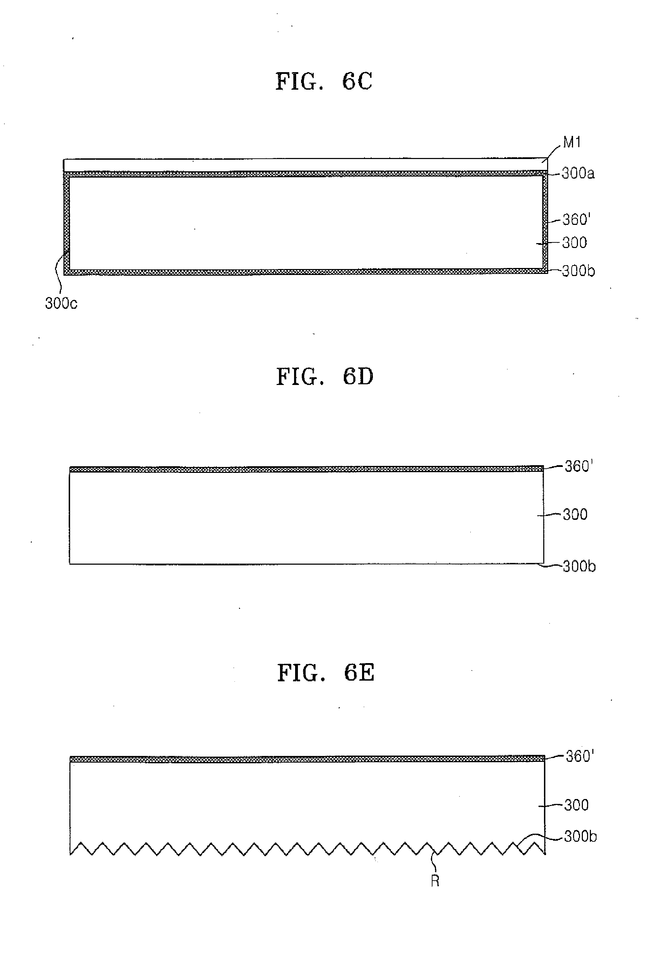

Then, an anti-etching layer M1 is formed on a partial region of the insulating layer 360', and etching is performed on the insulating layer 360' (FIGS. 6C and 6D). The anti-etching layer M1 may be formed to cover a first surface 300a of the semiconductor substrate 300 and remove a second surface 300b of the semiconductor substrate 300 and the insulating layer 360' of side surfaces thereof. For example, an acidic solution such as fluorhydric acid (HF), phosphoric acid (H₃PO₄), etc. having etching characteristics with respect to the insulating layer 360' may be used as the etchant. If etching is completely performed, the anti-etching layer M1 that is no more necessary may be removed.

Then, texturing is performed on the second surface 300b of the semiconductor substrate 300 (FIG. 6E). Etching is performed on the second surface 300b of the semiconductor substrate 300 by using the insulating layer 360' formed on the semiconductor substrate 300 as an etching mask. For example, a texture structure R of the roughness pattern may be formed on the surface of the semiconductor substrate 300 by using an alkaline solution such as KOH, NaOH, etc. and performing anisotropic etching with respect to the semiconductor substrate 300.

Then, a gap insulating layer 360 is formed by patterning the insulating layer 360' (FIGS. 6F ∼ 6H). That is, the gap insulating layer 360 is formed by removing the insulating layer 360' while remaining between the first and second semiconductor regions A1 and A2. For example, an anti-etching layer M2 is formed on a partial region of the insulating layer 360', an etchant is applied thereto, and the insulating layer 360' excluding the partial region protected by the anti-etching layer M2 is etched and removed. In this regard, an acidic solution such as fluorhydric acid (HF), phosphoric acid (H₃PO₄), etc. having etching characteristics with respect to the insulating layer 360' may be used as the etchant. If etching is completely performed, the anti-etching layer M2 that is no more necessary may be removed.

As will be described later, a passivation layer 301 is formed on the second surface 300b of the semiconductor substrate 300. Before the passivation layer 301 is formed, the semiconductor substrate 300 may be cleaned for effective passivation.

Then, the passivation layer 301 is formed on the textured second surface 300b of the semiconductor substrate 300 (FG. 6I). The passivation layer 301 may suppress recombination of carriers generated by the semiconductor substrate 300 and enhance collection efficiency of carriers.

For example, the passivation layer 301 may be formed of intrinsic amorphous silicon or doped amorphous silicon. For example, the passivation layer 301 may be doped with the same conductive type as that of the semiconductor substrate 300. For example, the passivation layer 301 may be formed as a heavily doped n+ layer on the surface of the n type semiconductor substrate 300, and may form a front surface field (FSF) to reduce the surface recombination loss. However, the passivation layer 301 may include a silicon oxide layer and a silicon nitride layer.

The passivation layer 301 may be formed by using a CVD method, for example, a CVD method using silane (SiH₄) that is a silicon containing gas.

The passivation layer 301 is formed on the second surface 300b (a light receiving surface) of the semiconductor substrate 300, and thus a band gap may be adjusted to reduce light absorption. For example, an additive is added to increase the band gap, and thus light absorption is reduced, and incident light may be absorbed into the semiconductor substrate 300.

Next, an antireflective layer 302 may be formed on the passivation layer 301 (FIG. 6J). The antireflective layer 302 may include a silicon oxide layer or a silicon nitride layer. For example, the antireflective layer 302 may be formed as a single layer of the silicon oxide layer or a combination layer of the silicon oxide layer and the silicon nitride layer having different refractive indexes.

Although the passivation layer 301 and the antireflective layer 302 have separate layer structures according to an embodiment of the present invention, the passivation layer 301 and the antireflective layer 302 may have the structure of a single layer according to another embodiment of the present invention. For example, a hydrogenated silicon nitride (SiN:H) layer may be formed to obtain passivation and antireflection effects.

Then, a first intrinsic semiconductor layer 311 is formed on the first surface 300a of the semiconductor substrate 300 (FIG. 6K). For example, the first intrinsic semiconductor layer 311 may be formed by using a CVD method using silane (SiH₄) that is the silicon containing gas, and may be formed of amorphous silicon.

Then, a first conductive semiconductor layer 313 is formed on the first intrinsic semiconductor layer 311 (FIG. 6K). For example, the first conductive semiconductor layer 313 may be doped in a p type that is a conductive type inverse to that of the semiconductor substrate 300, may be formed by using a CVD method using a doped gas (e.g. B₂H₆) and siliane (SiH₄) as sources, and may be formed of amorphous silicon.

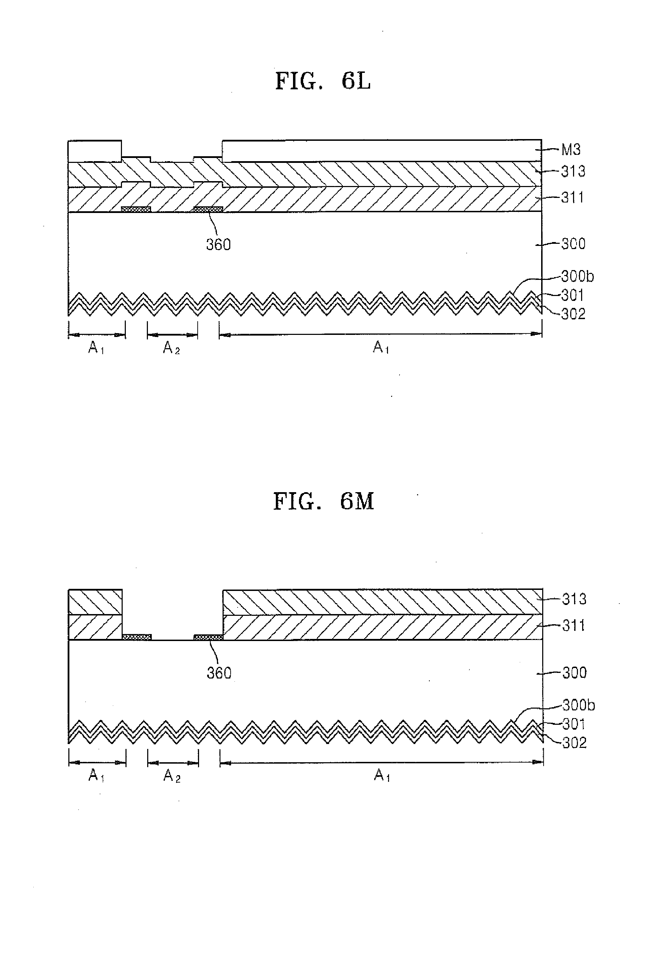

Then, the first intrinsic semiconductor layer 311 and the first conductive semiconductor layer 313 formed on the front surface of the semiconductor substrate 300 are patterned (FIGS. 6L and 6M). That is, the first intrinsic semiconductor layer 311 and the first conductive semiconductor layer 313 that are formed on the second semiconductor region A2 and the gap insulating layer 360 may be removed. However, in consideration of a processing margin, the first intrinsic semiconductor layer 311 and the first conductive semiconductor layer 313 may be formed on a part of the gap insulating layer 360 in order to reduce recombination loss due to a defective of the surface of the exposed semiconductor substrate 300 if there is a gap between the gap insulating layer 360 and the first semiconductor region A1.

With regard to a more detailed patterning process, an etching mask M3 is applied onto the first conductive semiconductor layer 313, and an exposed part may be removed through the etching mask M3, an acidic solution may be used as an etchant, for example, a mixing solution of nitride acid (HNO₃), fluorhydric acid (HF), and acetic acid (CH₃COOH or DI water). If etching is completely performed, the etching mask M3 that is no more necessary may be removed.

Through the patterning process above, the first intrinsic semiconductor layer 311 and the first conductive semiconductor layer 313 may be formed on the first semiconductor region A1, and the first semiconductor region A1 may have a relatively wider area than an area of the second semiconductor region A2. For example, the first semiconductor region A1 of an emitter that collects minority carriers is relatively wider than the second semiconductor region A2, thereby increasing collection efficiency of carriers. For example, the first semiconductor region A1 may surround the second semiconductor region A2 having an isolation type such as a dot or an island. According to another embodiment of the present invention, the first semiconductor region A1 may extend in a uniform width and may have a greater width than the width of the second semiconductor region A2 as shown in FIG. 4.

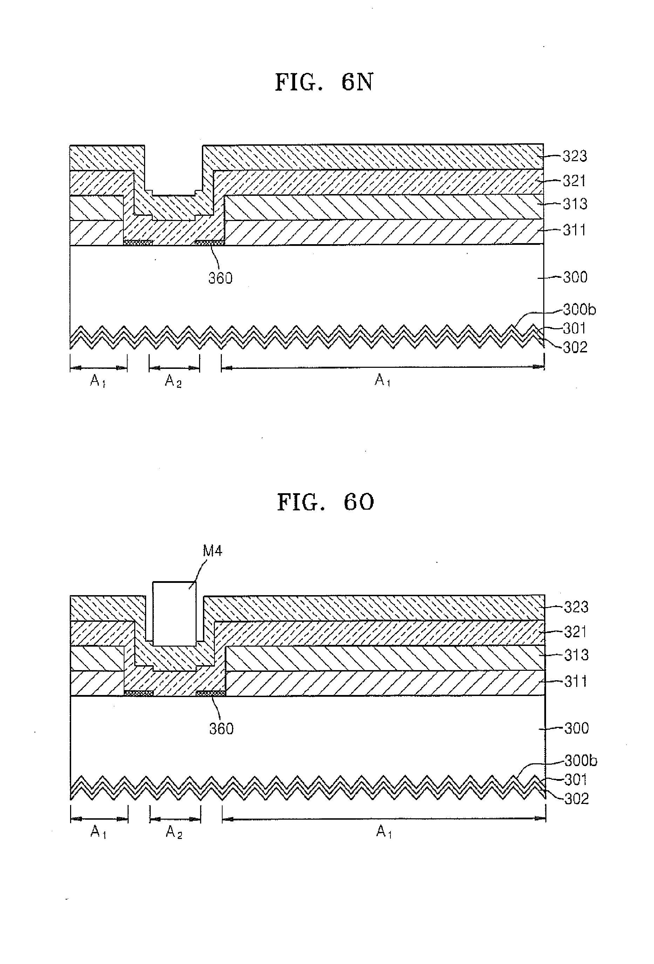

Then, a second intrinsic semiconductor layer 321 is formed on the semiconductor substrate 300 (FIG. 6N). For example, the second intrinsic semiconductor layer 321 may be formed by using a CVD method using silane (SiH₄) that is the silicon containing gas, and may be formed of amorphous silicon.

Then, a second conductive semiconductor layer 323 is formed on the second intrinsic semiconductor layer 321 (FIG. 6N). For example, the second conductive semiconductor layer 323 may be doped in an n type that is the same conductive type as that of the semiconductor substrate 300, may be formed by using a CVD method using a doped gas (e.g. B₂H₆) and siliane (SiH₄) as sources, and may be formed of amorphous silicon.

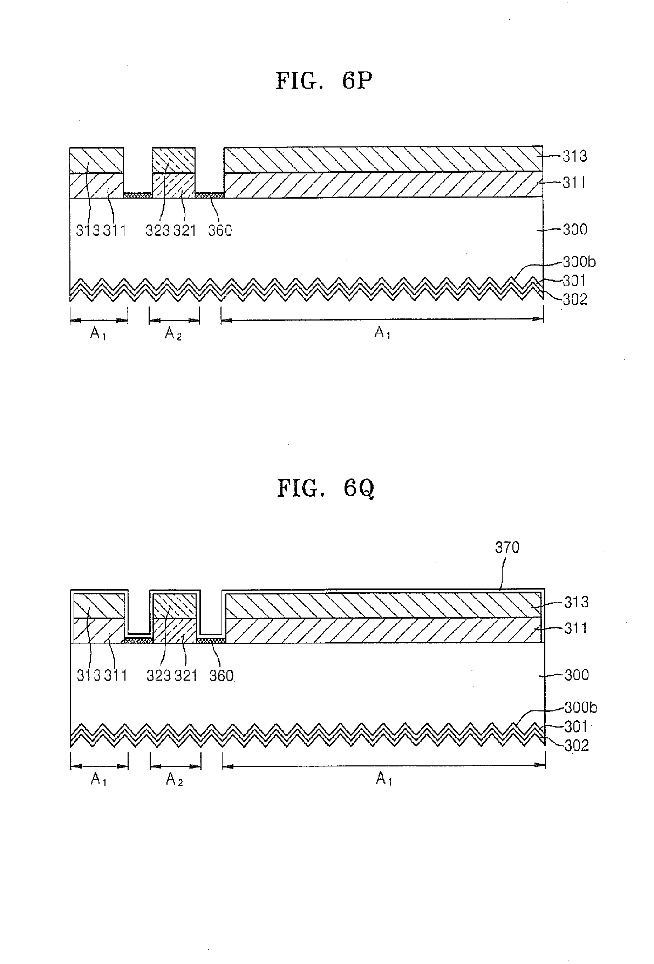

Then, the second intrinsic semiconductor layer 321 and the second conductive semiconductor layer 323 formed on the front surface of the semiconductor substrate 300 are patterned (FIGS. 6O and 6P). That is, the second intrinsic semiconductor layer 321 and the second conductive semiconductor layer 323 that are formed on the first semiconductor region A1 and the gap insulating layer 360 may be removed. However, in consideration of a processing margin, the second intrinsic semiconductor layer 321 and the second conductive semiconductor layer 323 may be formed on a part of the gap insulating layer 360 in order to reduce recombination loss due to a defective of the surface of the exposed semiconductor substrate 300 if there is a gap between the gap insulating layer 360 and the second semiconductor region A2.

With regard to a more detailed patterning process, an etching mask M4 is applied onto the second conductive semiconductor layer 323, and an exposed part may be removed through the etching mask M4, an acidic solution may be used as an etchant, for example, a mixing solution of nitride acid (HNO₃), fluorhydric acid (HF), and acetic acid (CH₃COOH or DI water). If etching is completely performed, the etching mask M4 that is no more necessary may be removed.

Through the patterning process above, the second intrinsic semiconductor layer 321 and the second conductive semiconductor layer 323 may be formed on the second semiconductor region A2, and the second semiconductor region A2 may have a relatively narrower area than the area of the first semiconductor region A1. For example, the second semiconductor region A2 may have an isolation type such as a dot or an island. According to another embodiment of the present invention, the second semiconductor region A2 may extend in a width narrower than the width of the first semiconductor region A1 as shown in FIG. 4.

Then, a transparent conductive layer 370 is formed on the first and second conductive semiconductor layers 313 and 323 (FIG. 6Q). For example, the transparent conducive layer 370 may be formed along the external surfaces of the first and second intrinsic semiconductor layers 311 and 321 and the first and second semiconductor layers 313 and 323 in a whole way.

The transparent conducive layer 370 may be formed of transparent conducting oxide (TCO) such as indium tin oxide (ITO), zinc oxide (ZnO), etc., and may be formed by using a sputtering or CVD method, etc.

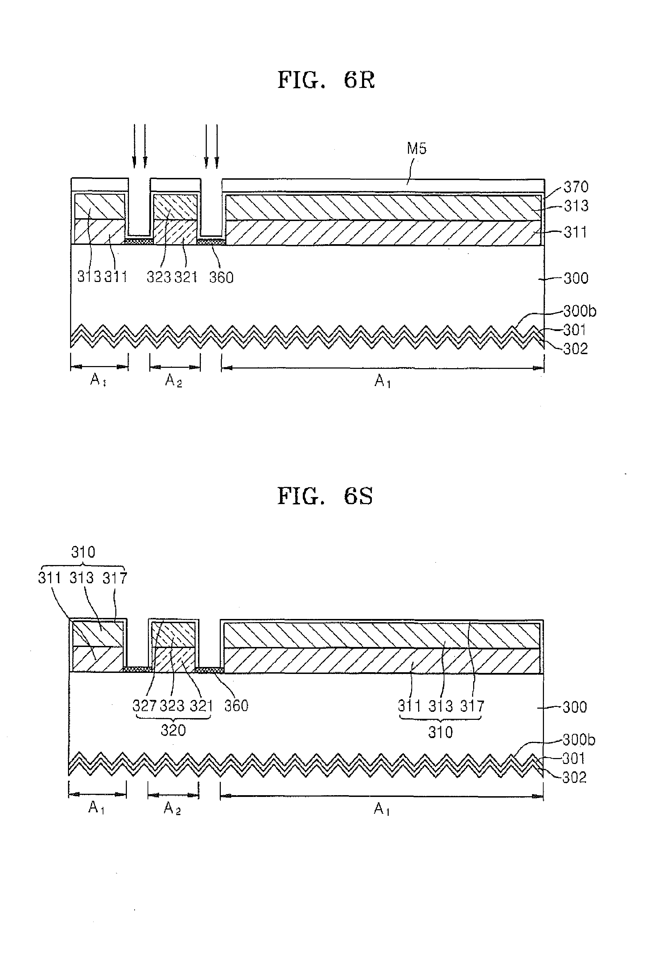

Then, the transparent conductive layer 370 formed on the overall surface of the semiconductor substrate 300 is separated (FIGS. 6R and 6S). More specifically, the transparent conductive layer 370 is separated into a first transparent conductive layer 317 on the first conducive semiconductor layer 313 and a second transparent conductive layer 327 on the second conductive semiconductor layer 323. For example, the transparent conductive layer 370 may be formed over the overall surface of the semiconductor substrate 300 through the process described above. Thus, the transparent conductive layer 370 on the gap insulating layer 360 is removed in order to prevent an electrical circuit short between the first and second conductive semiconductor layers 313 and 323. More specifically, an etching mask M5 is applied onto the transparent conductive layer 370, and the transparent conductive layer 370 exposed through the etching mask M5 is removed.

In this regard, an etchant that selectively exhibits etching characteristic with respect to the transparent conductive layer 370 on the gap insulating layer 360 that is resistant may be used. The gap insulating layer 360 may remain after the transparent conductive layer 370 is etched and removed. Through the preceding processes, the first and second semiconductor structures 310 and 320 are formed on the first and second semiconductor regions A1 and A2 on the semiconductor substrate 300.

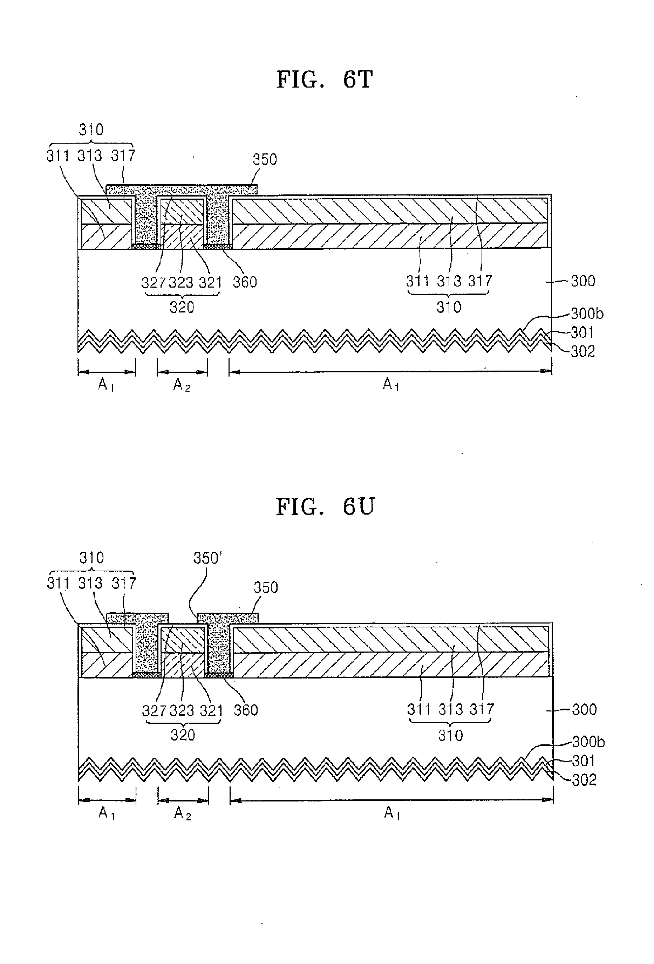

Then, an interlayer insulating layer 350 is formed over a part of the first semiconductor structure 310 (FIG. 6T). More specifically, the interlayer insulating layer 350 may be formed in a region in which a second electrode 332 on the first semiconductor structure 310 is to be formed. The interlayer insulating layer 350 is formed to insulate the second electrode 332 formed over the first and second semiconductor structures 310 and 320 and the first semiconductor structure 310 having a different conductive type from the second electrode 332 each other. The interlayer insulating layer 350 may be integrally formed over the second semiconductor structure as well as the first semiconductor structure 310.

For example, the interlayer insulating layer 350 may be formed of any electrically insulating materials without particularly limiting thereto. For example, the interlayer insulating layer 350 may be formed as the silicon oxide layer (SiOx) or the silicon nitride layer (SiNx) and by using a CVD method.

The interlayer insulating layer 350 may be formed over a part of the first semiconductor structure 310 and the second semiconductor structure 320, and may have a sufficient thickness in such a way that the first and second semiconductor structures 310 and 320 are planarized by burying between the first and second semiconductor structures 310 and 320. The second electrode 332 may be formed on the planar surface of the interlayer insulating layer 350 as will be described later.

Then, a via hole 350' is formed in the interlayer insulating layer 350 (FIG. 6U). That is, the via hole 350' is formed in the interlayer insulating layer 350 that covers the second semiconductor structure 320. The via hole 350' is formed to electrically connect the second semiconductor structure 320 and the second electrode 332. Although not shown, the via hole 350' my be formed by forming an etching mask (not shown) on the interlayer insulating layer 350, and etching and removing the interlayer insulating layer 350 exposed through the etching mask (not shown).

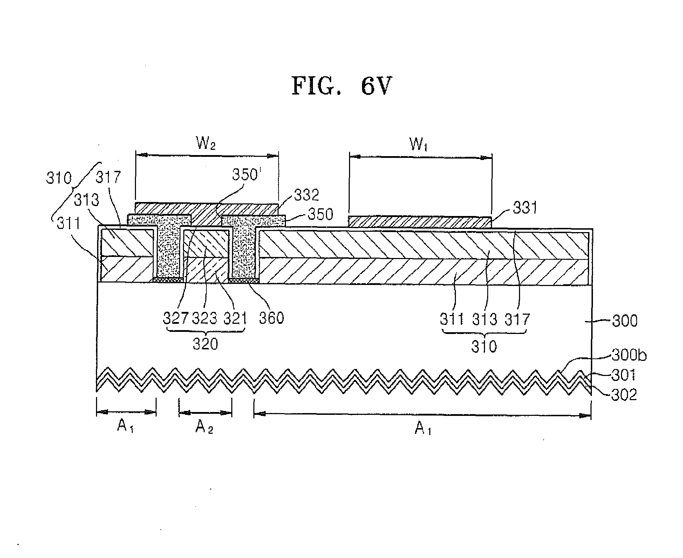

Then, the first and second electrodes 331 and 332 are formed on the first and second semiconductor structures 310 and 320 (FIG. 6V). The first and second electrodes 331 and 332 are connected to the first and second semiconductor structures 331 and 332 and thus carriers may be withdrawn to the outside. The first and second electrodes 331 and 332 may be formed of a metallic material such as silver (Ag), aluminum (Al), copper (Cu), nickel (Ni), etc. For example, the first and second electrodes 331 and 332 may be formed by thermal firing after pattern-printing a metal paste (not shown) by screenprinting.

The first and second electrodes 331 and 332 are uniformly formed having equal areas. For example, the first and second electrodes 331 and 332 may be formed substantially in the same line widths W1 and W2, in order to reduce a serial resistance of photocurrent by designing uniform areas of the first and second electrodes 331 and 332. For example, the first electrode 331 may be formed over a part of the first semiconductor structure 310, the second electrode 332 may be formed over a part of the first semiconductor structure 310 as well as the second semiconductor structure 320, and thus the second electrode 332 that expands may be uniform with the first electrode 331.

With regard to locations of the first and second electrodes 331 and 332, the first electrode 331 may be formed on a part of the first semiconductor structure 310 excluding the interlayer insulating layer 350, and the second electrode 332 may be formed over a part of the first semiconductor structure 310 in which the interlayer insulating layer 350 is formed and the second semiconductor structure 320. That is, the first electrode 331 is formed in a part of the first semiconductor region A1 that occupies a relatively wide region, and the second electrode 332 is formed in another part thereof.

It should be understood that the embodiments described herein should be considered in a descriptive sense only and not for purposes of limitation. Descriptions of features or aspects within each embodiment should typically be considered as available for other similar features or aspects in other embodiments.

## Claims

1. A photoelectric device comprising:
a substrate (100);
a first conductive semiconductor layer (113) situated over a first surface of the substrate (100);
a second conductive semiconductor layer (123) situated over the said first surface of the substrate (100);
a first electrode (131) situated over the first conductive semiconductor layer (113); and
a second electrode (132) situated over the second conductive semiconductor layer (123);
wherein one of the first and second conductive semiconductor layers (113, 123) is an emitter layer and the other of the first and second conductive semiconductor layers (113, 123) is a base layer;
**characterised in that** the first conductive semiconductor layer (113) covers a greater proportion of the said first surface of the substrate (100) than the second conductive semiconductor layer (123) covers.

2. A photoelectric device according to claim 1, wherein the said first electrode (131) covers substantially the same proportion of the said first surface of the substrate (100) that the second electrode (132) covers.

3. A photoelectric device according to claim 2, wherein the said first electrode (131) has substantially the same shape as the said second electrode (132).

4. A photoelectric device according to claim 1, 2 or 3, wherein the first conductive semiconductor (113) layer at least partly surrounds the second conductive semiconductor layer (123) within a predetermined plane that is substantially parallel to the said first surface of the substrate (100).

5. A photoelectric device according to any preceding claim, wherein the first conductive semiconductor layer (113) is located on two diametrically opposite sides of the said second conductive semiconductor layer (123) within a predetermined plane that is substantially parallel to the said first surface of the substrate (100).

6. A photoelectric device according to claim 5, wherein the second conductive semiconductor layer (123) takes the form of a stripe located within the said first conductive semiconductor layer (113) within the said predetermined plane.

7. A photoelectric device according to claim 4, wherein the first conductive semiconductor layer (113) encloses the second semiconductor layer (123) within the said predetermined plane.

8. A photoelectric device according to claim 7, wherein the said second semiconductor layer (123) defines a dot or island structure within the said predetermined plane.

9. A photoelectric device according to any preceding claim, wherein the said first and second semiconductor layers (113, 123) are co-planar.

10. A photoelectric device according to any preceding claim, further comprising at least one of:
a first intrinsic semiconductor layer (111) situated between the first conductive semiconductor layer (113) and the substrate (100); and
a second intrinsic semiconductor layer (121) situated between the second conductive semiconductor layer (123) and the substrate (100).

11. A photoelectric device according to any preceding claim, further comprising at least one of:
a first transparent conductive layer (115) situated between the first conductive semiconductor layer (113) and the first electrode (131);
and a second transparent conductive semiconductor layer (125) situated between the second conductive semiconductor layer (123) and the second electrode (132).

12. A photoelectric device according to any preceding claim, further comprising a first interlayer insulating layer (150a) situated between the first conductive semiconductor layer (113) and the second conductive semiconductor layer (123).

13. A photoelectric device according to claim 12, comprising a gap insulation layer (160) situated between a surface of the first interlayer insulating layer (150a) and the said first surface of the substrate (100).

14. A photoelectric device according to any preceding claim, comprising a second interlayer insulating layer (150b) that is located between the first conductive semiconductor layer (123) and the second electrode (132).

15. A photoelectric device according to claim 14, wherein the second interlayer insulating layer (150b) extends beyond the second electrode (132) in a plane that is substantially parallel to the said first surface of the substrate (100).

16. A photoelectric device according to claim 14 or 15, wherein the second interlayer insulating layer (150b) extends between the second conductive semiconductor layer and the said second electrode and comprises a via hole through which the second electrode forms an electrical connection with the second conductive semiconductor layer.

17. A photoelectric device according to claim 14, 15 or 16, when dependent upon claim 12 or 13, wherein the first interlayer insulating layer (150a) is integral with the second interlayer insulating layer (150b).
